Europäisches Patentamt

European Patent Office

Office européen des brevets

(11) Publication number: **0 289 197**
**A2**

## EUROPEAN PATENT APPLICATION

(21) Application number: 88303528.9

(22) Date of filing: 20.04.88

(51) Int. Cl.⁴: **G02F 1/01 , G02F 1/133**

(30) Priority: **27.04.87 JP 103709/87**

(43) Date of publication of application:
**02.11.88 Bulletin 88/44**

(84) Designated Contracting States:
**FR GB IT**

(71) Applicant: **SEIKO INSTRUMENTS INC.**
**31-1, Kameido 6-chome Koto-ku**
**Tokyo 136(JP)**

(72) Inventor: **Hanami, Takayoshi**
**c/o SEIKO INSTRUMENTS INC. 31-1, Kameido,**
**6-chome**
**Koto-ku Tokyo(JP)**

(74) Representative: **Miller, Joseph et al**
**J. MILLER & CO. Lincoln House 296-302 High**
**Holborn**
**London WC1V 7JH(GB)**

(54) **Electro-optical device.**

(57) An electro-optical device comprises an electro-optical panel (1) having two substrates (1a, 1b), at least the first substrate (1a) having a first group of lead terminals on edges of the substrate projecting beyond the other substrate (1b). A circuit board (2) has a second group of lead terminals corresponding to the first group of the lead terminals, and connectors (3a,3b) electrically connect together the first and second groups of lead terminals. A frame (5) secures the electro-optical panel (1) and connectors (3a,3b) to the circuit board (2) and buffers (4a,4b) are provided between the electro-optical panel (1) and the frame (5).

EP 0 289 197 A2

FIG.1

## ELECTRO OPTICAL DEVICE

The present invention relates to electro-optical devices, such as display devices, printer shutters or the like, which may employ various kinds of electro-optical elements, such as liquid crystal, plasma, EL or electrochromic elements.

In Japanese Utility Model Publication No. 58-46450 (46450/1983), there is disclosed an electro-optical device which has an electro-optical panel having sets of electrodes at right angles, the electrodes of each set extending parallel to each other at substantially equal distances with lead terminals for the electrodes, and a circuit board having terminals corresponding to the lead terminals, the lead terminals on the electro-optical panel and the circuit board being electrically connected together by a rubber connector which is formed by alternately laminating an electrically conductive rubber material and an insulating rubber material with a sufficiently small pitch so that one or more conductive portions of the connector are in contact with the electrode surface of only one lead terminal at all times.

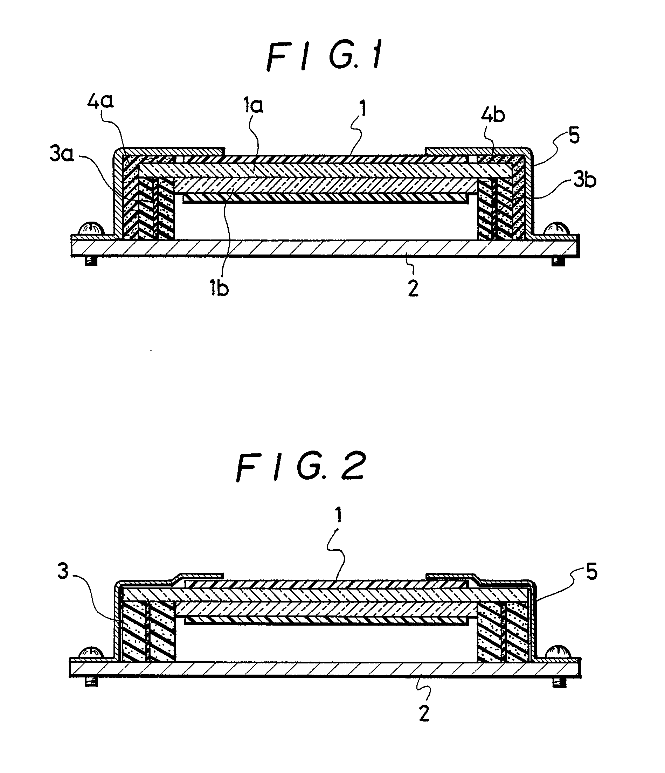

Such an electro-optical device is described hereinafter with reference to Figure 2 of the accompanying drawings, and suffers from the following disadvantages. The electro-optical device (Figure 2) has a frame 5 made of a metal or resin material for compressibly securing an electro-optical panel 1 and connectors 3 to a circuit board 2 in order to enable the electrode surfaces of the lead terminals of the electro-optical panel 1 and those of the circuit board 2 to be brought into sufficiently close contact with the conductive portions of the rubber connectors 3 so that the contact resistance is minimized. Because the frame 5 is disposed in close proximity to the electro-optical panel 1 which uses glass or the like as a substrate thereof, if external force is applied to the device, for example, when it is accidentally dropped, the glass substrate may collide with the frame 5 on impact, resulting in destruction of the substrate.

To assemble this electro-optical device, two long resilient compressible connectors 3 are placed at predetermined positions, respectively, on the circuit board 2 in such a manner that the connectors 3 stand as straight as possible, and the electro-optical panel 1 is placed on the connectors 3 by visually adjusting the positions of the connectors 3 so that the electrode terminals of the panel 1 coincide with the upper ends of the connectors 3, which involves considerably inferior operating efficiency and also variations in the positional accuracy.

It is a primary object of the present invention to provide an electro-optical device which is so designed that the chance of destruction of the electro-optical panel 1 when the device is impacted due to a fall or the like, is reduced.

According to the present invention, there is therefore provided an electro-optical device comprising an electro-optical panel including two substrates, at least one of which has a first group of lead terminals, a circuit board having a second group of lead terminals corresponding to the first group of the lead terminals, at least one connector for electrically connecting together the first and second groups of the lead terminals, and a frame for securing both the electro-optical panel and connector to the circuit board, characterised by a buffer provided between at least a portion of the electro-optical panel and the frame.

The provision of a buffer between the frame and the electro-optical panel, preferably connected to a resilient connector made of a rubber, plastics or the like which is employed for electrical connection, thereby prevents destruction of the electro-optical panel even if a physical force is applied to the device due to a fall or the like.

By virtue of the above described arrangement, if the device is impacted due to a fall or the like the impact is transmitted to the electro-optical panel after being relieved by the buffer so that it is possible to prevent destruction of the panel.

The buffer may have an L-shaped cross section.

The buffer and the connector may be formed in a single unitary body.

The body of the buffer and the connector may have a groove which is slightly narrower than the thickness of the one substrate of the electro-optical panel.

The connector may have a columnar construction formed by alternately laminating a plurality of compressible, resilient and electro-conductive plates and a plurality of compressible, resilient and non-conductive plates.

The other of the substrates may have a third group of lead terminals connecting to a fourth group of lead terminals of the circuit board through at least one connector.

The connector may be a compressible, resilient connector.

Alternatively, the connector may be a flexible printed circuit.

The frame may be made of metal or plastics.

One preferred embodiment of electro-optical device according to the present invention is particularly described hereinafter with reference to the accompanying drawings, in which:-

Figure 1 is a sectional view of the electro-optical device; and

Figure 2 is a similar sectional view of a known electro-optical device, referred to hereinbefore.

A preferred embodiment of electro-optical device (Figure 1) includes an electro-optical panel 1 in which an electro-optical element, such as a liquid crystal, plasma, EL or electrochromic element, is sandwiched between two substrates 1a and 1b having electrodes on their adjacent faces to enable a voltage to be applied to the sandwiched element. A multiplicity of electrodes are formed on the inner surface of each of the substrates 1a and 1b, the electrodes on a substrate extending parallel to each other at substantially equal intervals, and the electrodes on the inner surface of one substrate being orthogonal to the electrodes on the inner surface of the other substrate, thus enabling a voltage to be selectively applied to the electro-optical element sandwiched between the two substrates. The substrates 1a and 1b are so dimensioned and disposed that the edges of the substrate 1a project beyond the overlapped area of the substrates 1a and 1b, in one direction as shown in Figure 1, whilst the edges of the substrate 1b similarly project in a direction perpendicular to the one direction. The multiplicity of electrodes which are formed on the inner surfaces of the substrates 1a and 1b extend to the ends of the substrates and are therefore exposed on the edges located outside the cell formed by the overlapped portions of the substrates. The electrodes on the edges of the substrate 1a are electrically connected by compressible, resilient connectors 3a and 3b which are disposed under the left and right ends, respectively, of the substrate 1a to a multiplicity of electrical lead patterns which are formed on a circuit board 2. Each of the connectors 3a and 3b is a columnar member which is formed by alternately laminating a multiplicity of plates made of a compressible, resilient, electroconductive material (e.g. an electrically conductive rubber) and a multiplicity of plates made of a compressible, resilient, electrically non-conductive material (e.g. an insulating rubber), as disclosed, for example, in US-A-4,142,781, the columnar members being placed sideways. The connectors 3a and 3b are sufficiently long to cover all the electrodes which terminate at the ends of the substrate 1a. Alternate electrodes may end adjacent the edge of the overlapped area, so that the each end edge of the substrate 1a may expose only half the electrodes on the inner surface of the substrate 1a. In this case the exposed ends of the electrodes may be wider than the parts within the cell. The multiplicity of electrodes which are formed on the inner surface of the substrate 1b may be connected to the multiplicity of electrical lead patterns on the circuit board 2 by similar compressible resilient connectors, or may be connected by inverted L-shaped or U-shaped cross-section connectors, or by flexible printed circuits or the like, which are disposed at two ends of the substrate 1b.

The ends of the substrate 1a have buffers 4a and 4b which are of inverted L-shaped cross-section and which are made of a compressible, resilient material, such as a rubber, plastics or the like. The buffers 4a and 4b have substantially the same length as that of the connectors 3a and 3b and they are connected to the respective connectors 3a and 3b by means of adhesive or the like to form a unitary body. The height of the stroke of the L of the cross-section of the buffers 4a and 4b is greater than the corresponding height of the connectors 3a and 3b. The foot of the L of the cross-section of the buffers 4a and 4b is spaced from the top of the connectors 3a and 3b by a distance which is slightly less than the thickness of the substrate 1a. Thus the unitary body of the buffer 4a and the connector 3a has a groove of a size to receive the end edge of the substrate 1a tightly. Similarly, the unitary body of the buffer 4b and the connector 3b has a groove to receive the other end of the substrate 1a. The thickness of the foot of the L is such as to correspond with that of a transparent sheet on the outer surface of the substrate 1a. A frame 5 made of metal, plastics or the like, is rigidly secured to the circuit board 2. The frame 5 is of generally Z shape in cross-section, with a flat foot bolted to the circuit board 2, a mid-section extending at right angles to the foot alongside the stroke of the L of the cross-section of the buffer, and an end portion at right angles to the mid-section and extending over the foot of the L of the cross-section of the buffer and over the edge of the transparent sheet on the outer surface of the substrate 1a. The frame 5 may be rectangular so as to engage the four edges of the electro-optical panel 1, particularly if the substrate 1b also has resilient, compressible connectors and buffers. The frame 5 enables the electrodes on the substrate 1a and those on the connectors 3a and 3b to be brought into satisfactorily close contact with each other and also permits the electrodes on the connectors 3a and 3b to be brought into satisfactorily close contact with those on the circuit board 2, thus minimizing contact resistance. The frame 5 further serves rigidly to secure the electro-optical panel 1, the connectors 3a and 3b, the buffers 4a and 4b and the like to the circuit board 2.

To assemble this electro-optical device, a flexible printed circuit or other connector for circuit connection is attached to the panel substrate 1b, and the two ends of the substrate 1a of the electro-optical panel 1 are forced into the grooves which are defined between the resilient connectors 3a and 3b and the resilient buffers 4a and 4b, respectively. Thereafter, these members thus assembled together in one unit are rigidly secured to the circuit board 2 by the frame 5. With the arrangement described, the compressible, resilient material of a buffer is disposed between the face of the outer substrate 1a and the frame 5, and between the end edge of the substrate 1a and the frame 5.

Although the impact resistance of the device is improved with a construction in which the buffers 4a and 4b are provided separately from the connectors 3a and 3b, much improved operating efficiency and positional accuracy is obtainable in addition to impact resistance, by virtue of the arrangement in the described embodiment wherein the buffers 4a and 4b and the connectors 3a and 3b form unitary bodies, each with a groove for receiving the end portions of the substrate 1a of the electro-optical panel 1. It will be appreciated that, if the frame 5 is non-conductive, the buffer 4a and connector 3a may be formed integrally as may the buffer 4b and connector 3b.

**Claims**

1. An electro-optical device comprising an electro-optical panel (1) including two substrates (1a, 1b), at least one (1a) of which has a first group of lead terminals, a circuit board (2) having a second group of lead terminals corresponding to the first group of the lead terminals, at least one connector (3a; 3b) for electrically connecting together the first and second groups of the lead terminals, and a frame (5) for securing both the electro-optical panel (1) and connector (3a, 3b) to the circuit board (2), characterised by a buffer (4a, 4b) provided between at least a portion of the electro-optical panel (1) and the frame (5).

2. A device according to claim 11, wherein the buffer (4a,4b) has an L-shaped cross-section.

3. A device according to claim 1 or 2 wherein the buffer (4a, 4b) is made essentially of a compressible, resilient material, such as a rubber, plastics or the like.

4. A device according to claim 1, 2 or 3, wherein the buffer (4a; 4b) and the connector (3a; 3b) are formed in a single unitary body.

5. A device according to claim 4, wherein the body of the buffer (4a, 4b) and the connector (3a, 3b) has a groove which is slightly narrower than the thickness of the one substrate (1a) of the electro-optical panel (1).

6. A device according to any preceding claim, wherein the connector (3a, 3b) has a columnar construction formed by alternately laminating a plurality of compressible, resilient and electro-conductive plates and a plurality of compressible, resilient and non-conductive plates.

7. A device according to any preceding claim, wherein the other (1b) of the substrates has a third group of lead terminals connecting to a fourth group of lead terminals of the circuit board (2) through at least one connector.

8. A device according to claim 7, wherein the connector is a compressible, resilient connector.

9. A device according to claim 7 wherein the connector is a flexible printed circuit.

10. A device according to any preceding claim, wherein the frame is made of metal or plastics.

# F I G. 1

# F I G. 2